# FASCICULE DE BREVET EUROPEEN

(11) **EP 0 556 927 B1**
(45) Date de publication et mention de la délivrance du brevet: **02.05.1997**
(21) Numéro de dépôt: 93200465.8
(22) Date de dépôt: 18.02.1993
(51) Int. Cl.: H03F 1/32

(54) **Circuit différentiel à haute linéarité**
Differenzschaltung mit hoher Linearität
Differential circuit with high linearity

(30) Priorité: 19.02.1992 FR 9201884
(43) Date de publication de la demande: 25.08.1993
(73) Titulaire: PHILIPS COMPOSANTS ET SEMICONDUCTEURS, 92150 Suresnes (FR); Philips Electronics N.V., 5621 BA Eindhoven (NL)
(72) Inventeur: Perraud, Jean-Claude, F-75008 Paris (FR)
(74) Mandataire: Charpail, François

(56) Documents cités:
- US-A- 4 156 283
- US-A- 4 605 906
- FREQUENZ vol. 42, no. 4, Avril 1988, BERLIN DE pages 117 - 120 P. HARZ 'A LINEARIZED DIFFERENTIAL AMPLIFIER'

## Description

La présente invention concerne un circuit différentiel à haute linéarité comportant une source de courant constant alimentant, à partir d'une borne de référence de tension d'alimentation, les trajets émetteur-collecteur d'une paire différentielle de transistors d'entrée, chacun de ces transistors d'entrée ayant son collecteur alimenté à partir d'une autre borne de la tension d'alimentation, sa base qui reçoit un signal de tension d'entrée et son émetteur étant relié à la source de courant constant via une résistance de charge d'émetteur de valeur R, pratiquement identique pour chacun des transistors d'entrée.

Un tel circuit différentiel est à la base de la plupart des étages d'entrée d'amplificateurs différentiels connus, où un signal de sortie de cet étage peut être prélevé soit sur les résistances de charge d'émetteur soit encore sur des impédances appairées insérées dans la liaison des collecteurs des transistors de la paire différentielle vers ladite autre borne d'alimentation.

L'invention vise plus particulièrement à procurer un circuit différentiel intégrable dont le gain proche de (ou inférieur à) l'unité, soit bien défini et reproductible, et dont la linéarité du signal de sortie par rapport au signal d'entrée soit respectée à mieux que 1%. Un circuit différentiel de gain en tension égal à 1 est connu de l'article : "A 10-b 75-MSPS Subranging A/D Converter with Integrated Sample and Hold" - Reinhard Petschacher et al - publié dans IEEE Journal of Solid-State Circuits, Vol.25, n°6, dec 1990. Ce circuit présente une compensation de linéarité par l'insertion d'une jonction polarisée en direct dans la liaison du collecteur de chacun des transistors d'entrée vers la borne de tension d'alimentation.

Le circuit connu présente l'inconvénient que le signal de sortie est fortement limité en amplitude.

Un circuit différentiel à faible gain et haute linéarité est recherché dans des applications de mesure d'un signal analogique et entre-autres dans des convertisseurs analogiques-digitaux.

Une autre manière connue d'obtenir une très bonne linéarité consiste à utiliser un amplificateur opérationnel auquel on applique une contre-réaction élevée de manière à fixer le gain recherché, mais cette solution n'est pas pleinement satisfaisante en ce qui concerne la limitation de bande passante et/ou la consommation de courant et également du point de vue de la complexité du circuit, donc de la surface de semiconducteur nécessaire et, par voie de conséquence, de son prix relativement élevé.

Un des buts de l'invention est donc de procurer un circuit différentiel à haute linéarité qui soit d'une structure moins complexe que celle mettant en oeuvre un amplificateur opérationnel et dont les performances de bande passante et de consommation soient plus satisfaisantes.

Un autre but de l'invention est d'améliorer la linéarité d'un circuit différentiel comportant une paire de transistors d'entrée, et particulièrement pour des signaux d'entrée ayant une excursion de tension élevée, de l'ordre du Volt ou plus, tout en conservant une bande passante élevée, une excursion de tension de sortie élevée, et une consommation en courant relativement faible.

De tels buts sont atteints, selon l'invention, par un circuit conforme au paragraphe introductif, caractérisé en ce qu'entre l'émetteur de chaque transistor d'entrée et la source de courant est insérée une branche de commande d'un miroir de courant qui comporte q jonctions polarisées en direct, en ce qu'une branche de sortie du miroir de courant est reliée à ladite autre borne d'alimentation via une résistance de charge de sortie, en série avec un nombre non nul k de jonctions polarisées en direct, et en ce que la valeur de chacune des résistances de charge de sortie est choisie pratiquement égale à k.R/(1+q) procurant ainsi un gain de tension en sortie égal à k/(1+q), par rapport au signal de tension d'entrée.

Pour un miroir de courant présentant une seule jonction en direct, (q=1), le gain en tension d'un tel circuit peut être choisi parmi les valeurs : 1/2, 1, 1½... selon que le nombre k de jonctions utilisées est respectivement égal à 1, 2, 3... les applications les plus intéressantes étant pour un choix de gain égal à ½ ou 1 pour lequel l'excursion en tension du signal de sortie n'est que peu limitée par l'insertion des jonctions et le saut de tension correspondant.

D'autres valeurs discrètes de gain peuvent également être obtenues dans un mode de mise en oeuvre similaire de l'invention caractérisé en ce qu'entre l'émetteur de chaque transistor d'entrée et la source de courant est en outre inséré, en série avec la branche de commande du miroir de courant, un nombre p de jonctions polarisées en direct, et en ce que la valeur de chacune des résistances de charge de sortie est choisie pratiquement égale à k.R/(1+p+q) procurant ainsi un gain de tension en sortie égal à k/(1+p+q) .

C'est ainsi que l'on peut obtenir par exemple un gain de 1/3 ou 2/3 en choisissant q=1 p=1 et k=1 ou k=2.

Dans tous les cas, la linéarité du signal de sortie est assurée du fait que le courant émetteur de chaque transistor d'entrée, affecté d'une composante non linéaire par rapport à la tension d'entrée, est recopié dans la branche de sortie de chaque miroir de courant où il produit une tension de sortie sur la résistance de charge de sortie augmentée de la tension des k jonctions en direct, ces éléments étant convenablement proportionnés pour procurer une compensation en tension de la composante non linéaire de courant.

Le circuit selon l'invention offre l'avantage, grâce à l'utilisation des miroirs de courant, d'une possibilité d'excursion de tension de sortie plus élevée que celle d'un circuit dans lequel la sortie serait prélevée sur une charge de collecteur des transistors de la paire de transistors d'entrée.

Le circuit selon l'invention conserve une structure très simple, facile à intégrer et il peut être alimenté avec un courant relativement faible tout en conservant une bande passante élevée, essentiellement déterminée par la fréquence de coupure des transistors utilisés.

Pour conserver la possibilité d'une excursion de tension élevée à l'entrée, le circuit selon l'invention utilise de préférence des miroirs de courant dans leur structure connue la plus simple c'est-à-dire comportant uniquement un transistor monté en diode, dans la branche de commande. Dans les miroirs de courants de ce type, une petite erreur de recopie du courant de commande est produite du fait que la valeur d'un courant de base de l'un des transistors du miroir de courant n'est pas recopié dans la branche de sortie.

Une correction partielle de cette petite erreur, correction qui est connue en soi, peut être appliquée dans le circuit selon l'invention dans un mode de mise en oeuvre caractérisé en ce que dans chacun des miroirs de courant ladite banche de commande comprenant un transistor de commande connecté en diode, l'émetteur de ce transistor de commande est relié à la source de courant constant à travers une résistance de compensation de courant tandis que la branche de sortie du miroir de courant comporte un transistor dont l'émetteur est directement connecté à la source de courant constant.

La valeur de la résistance de compensation est déterminée par un calcul simple en tenant compte de l'excursion de tension d'entrée maximale prévue pour le circuit.

On a observé en pratique, dans un exemple d'application où le gain était prévu de 1/2, que la linéarité du signal de sortie était assurée à 1/1000 près pour un signal d'entrée de 1 Volt appliqué de manière symétrique. Toutefois pour un signal d'entrée non symétrique, la linéarité était un peu moins bonne et assurée seulement à 5/1000 près.

Cette différence de performances selon le mode d'application du signal d'entrée provient principalement de l'effet Early présenté par les transistors de la paire différentielle d'entrée.

Cette petite erreur peut encore être pratiquement éliminée selon un autre mode de mise en oeuvre de l'invention caractérisé en ce que dans chacun des miroirs de courant, ladite branche de sortie comporte un étage cascode constitué par un transistor additionnel dont la base est polarisée à l'aide d'un décalage de tension déterminé par rapport au noeud constitué par la source de courant constant et les miroirs de courant, dont le collecteur alimente la résistance de charge de sortie en série avec le nombre détemriné k de jonctions, et dont l'émetteur est connecté au collecteur du transistor de la branche de sortie du miroir de courant.

Selon ce mode de mise en oeuvre, l'insertion d'une tension de déchet supplémentaire dans la branche de sortie des miroirs de courant n'est pas un inconvénient dans tous les cas où le gain recherché est voisin de l'unité, ou inférieur.

L'expérience a montré que dans ce cas, la linéarité du signal de sortie était alors assurée à 1/1000 près, ou mieux, même pour un signal d'entrée de 1 Volt appliqué de manière non symétrique.

La description qui va suivre en regard des dessins annexés, donnés à titre d'exemples non limitatifs, fera bien comprendre en quoi consiste l'invention et comment elle peut être réalisée.
La figure 1 représente le schéma électrique d'un circuit différentiel selon le mode le plus simple de mise en oeuvre de l'invention, dans lequel le gain en tension est égal à 1/2,
la figure 2 indique le schéma électrique d'un circuit selon un mode de mise en oeuvre de l'invention où le gain peut être choisi parmi plusieurs valeurs discrètes,
la figure 3 montre le schéma d'un circuit selon l'invention comportant plusieurs moyens additionnels de compensation des erreurs résiduelles de linéarité.

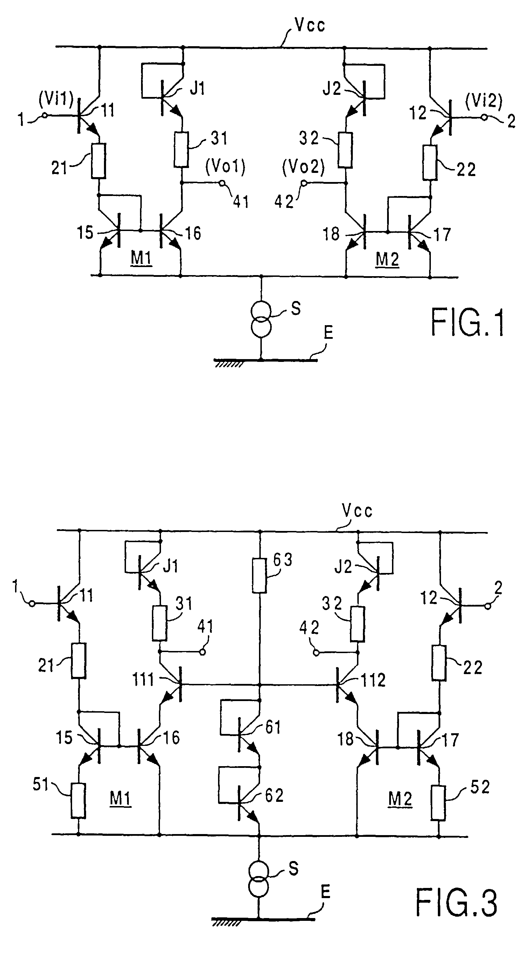

Le schéma électrique d'un premier exemple des circuits différentiels à haute linéarité conforme à l'invention est représenté à la figure 1.

Une source de courant constant S alimente à partir d'une borne de référence de tension d'alimentation E le trajet émetteur-collecteur d'une paire différentielle de transistors d'entrée respectivement 11 et 12. Chacun de ces transistors 11 et 12 a son collecteur directement connecté à une autre borne V_{cc} de la tension d'alimentation, sa base reçoit un signal de tension d'entrée respectivement Vᵢ₁ et Vᵢ₂ sur des bornes d'entrée respectives 1 et 2 et a son émetteur relié à la source de courant constant S via une résistance de charge d'émetteur 21 respectivement 22 de même valeur R.

Conformément à l'invention, entre l'émetteur de chaque transistor d'entrée 11, 12 et la source de courant constant S est insérée une branche de commande d'un miroir de courant M₁, M₂, dont la branche de sortie est reliée à ladite autre borne d'alimentation V_{cc} via une résistance de charge de sortie 31 respectivement 32 qui est connectée en série avec une jonction J₁, J₂ polarisée en direct. Chacun des miroirs de courant M₁, M₂ est simplement constitué d'un transistor d'entrée 15, 17 connecté en diode, couplé par sa base à un transistor de sortie 16, 18 dont les branches de sortie de ces miroirs fournissent un courant très sensiblement égal au courant de commande à l'entrée de ces miroirs.

Un signal de tension différentielle de sortie V₀₁, V₀₂ est prélevé sur des bornes respectivement 41 et 42 reliées aux noeuds respectifs formés entre les collecteurs des transistors de sortie des miroirs M₁ et M₂ et leurs charges respectives formées par le branchement-série des résistances de charge de sortie 31, 32 et des jonctions J₁, J₂.

Ce montage permet d'obtenir un gain en tension de sortie par rapport à la tension d'entrée très sensiblement égal à 1/2 lorsque la valeur des résistances 31 et 32 est choisie égale à R/2.

Dans ces conditions la linéarité en tension du signal de sortie est assurée du fait que dans chacune des voies du circuit différentiel, le courant d'émetteur de chacun des transistors d'entrée est déterminé de manière différentielle à partir de la tension d'entrée d'une part par la résistance de charge d'émetteur de valeur R et d'autre part par les impédances non linéaires de deux jonctions, la jonction base-émetteur du transistor d'entrée 11, 12 et la jonction de la branche de commande des miroirs de courant M₁, M₂ (transistors 15, 17). Ce courant d'émetteur est recopié dans la branche de sortie de chacun des miroirs de courant M₁, M₂ et développe une tension par rapport à la tension d'alimentation V_{cc} qui est déterminée d'une part par les résistances de charge de sortie 31, 32 et d'autre part par les impédances non linéaires des jonctions J₁ et J₂. La somme des impédances de sortie étant égale exactement à la moitié de l'impédance d'entrée, le gain est alors égal à 1/2 et l'effet des impédances non linéaires se trouve essentiellement éliminé.

L'invention ne se limite pas à un circuit différentiel de gain 1/2 mais permet au contraire de choisir différentes valeurs discrètes de gain en tension en appliquant la même idée de base.

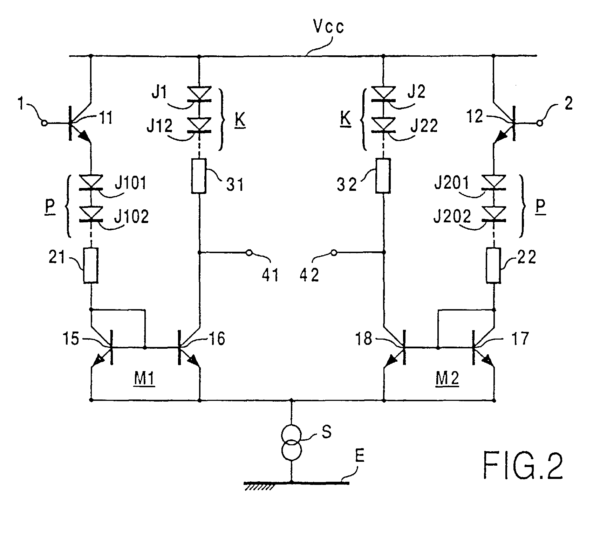

La figure 2 indique le schéma d'un circuit différentiel selon l'invention pour lequel le gain peut être choisi parmi plusieurs valeurs discrètes. Sur cette figure les éléments ayant une même fonction que dans la figure 1 sont affectés des mêmes signes de référence. Par rapport au circuit décrit à la figure 1, le circuit de la figure 2 se distingue par l'insertion de jonctions supplémentaires toutes polarisées dans le sens direct, soit dans les branches de commande des miroirs de courant M₁ et M₂ en tant que charges d'entrées supplémentaires, soit dans les branches de sortie des mêmes miroirs, soit encore dans les deux branches. Plus précisément, lorsqu'on insère k jonctions tels que J₁, J₁₂..., J₂, J₂₂..., on choisit alors une valeur de résistance de charge de sortie 31, 32 égale à kR/2 et le gain en sortie est fourni alors par la valeur k/2. D'autre part si l'on insère un nombre p de jonctions supplémentaires, polarisées en direct, en série avec la branche de commande des miroirs de courant M₁ et M₂ telles que J₁₀₁, J₁₀₂..., J₂₀₁, J₂₀₂..., la valeur de chaque résistance de charge de sortie 31, 32 est alors choisie égale à k.R/(2+p) et le gain en tension du circuit devient égal à k/(2+p). Par exemple, si une jonction J₁₀₁, J₂₀₁ est insérée dans la branche de commande des miroirs de courant M₁, M₂, (p = 1) tandis que deux jonctions sont insérées dans chacune des branches de sortie des miroirs de courant, J₁, J₁₂, J₂, J₂₂, (k = 2) un gain de 2/3 est obtenu avec compensation des impédances non linéaires lorsque les résistances de charge de sortie 31 et 32 ont pour valeurs 2R/3. Dans les exemples décrits, les miroirs de courant M₁ et M₂ sont du type le plus simple selon lequel la branche de commande n'interpose qu'une seule jonction polarisée en direct (transistors 15 et 17, montés en diode). D'autres types de miroirs de courant peuvent également être utilisés, qui insèrent q jonctions polarisées en direct, avec q>1. Dans ce cas, les résistances de charge de sortie 31 et 32 ont une valeur choisie égale à k.R/(1+p+q) et le gain obtenu devient : k/(1+p+q).

Il est clair que dans le cas où la tension d'alimentation V_{cc} est relativement peu importante (5 Volts), le circuit différentiel tel que représenté à la figure 2 est particulièrement intéressant pour des nombres p et k de jonctions insérées restant faibles de manière à ne pas limiter exagérément la tension d'excursion des signaux d'entrée et de sortie par la tension d'insertion des jonctions insérées de manière supplémentaire par rapport au circuit représenté à la figure 1.

Les circuits présentés aux figures 1 et 2 présentent une excellente linéarité de tension de sortie particulièrement lorsque la tension d'entrée est appliquée de manière symétrique et ce, jusqu'à une tension d'entrée de 1 Volt crête. En mode d'attaque non symétrique un tel circuit est un peu moins performant et fait apparaître un défaut de linéarité de l'ordre de 5/1000. De petites erreurs résiduelles peuvent être compensées de manière simple dans un mode de mise en oeuvre de l'invention représenté à la figure 3.

La figure 3 présente le schéma d'un circuit différentiel de gain 1/2 similaire de celui représenté à la figure 1 et où les éléments de même fonction ont été affectés par des mêmes signes de référence. Par rapport au schéma de la figure 1 des erreurs résiduelles de linéarité ont été compensées par l'insertion de quelques éléments additionnels. Les miroirs de courant M₁ et M₂ de la figure 1, dans leur forme la plus simple présentent une petite erreur de recopie du courant d'entrée, du fait que le courant de base des transistors 16 et 18 est prélevé dans la branche de commande sans être recopié dans la branche de sortie. Cette erreur est d'autant plus faible que le gain des transistors utilisé est élevé et elle peut être au moins partiellement compensée, d'une manière connue en soi, qui consiste à insérer des résistances de compensation de courant 51 et 52 entre les émetteurs des transistors de commande 15 et 17, connectés en diodes, et la borne de la source de courant constant S qui est opposée à la borne de référence de tension d'alimentation E. Dans les miroirs de courant M₁ et M₂, les transistors de sortie 16 et 18 ont leurs émetteurs directement connectés à la source de courant S. D'autres solutions sont également possibles pour améliorer l'exactitude de recopie du courant d'entrée de ces miroirs mais la solution indiquée permet de minimiser la tension d'insertion supplémentaire introduite dans la branche de commande de ces miroirs.
La valeur des résistances de compensation de courant 51 et 52 est aisément déterminée en fonction de l'excursion de tension maximale prévue pour le circuit différentiel considéré. Comme on le sait, une telle compensation n'est pas parfaite du fait qu'elle n'applique pas un supplément de courant de sortie exactement proportionnel au courant de commande. On choisira donc une valeur de résistance 51 et 52 calculée pour procurer une compensation exacte au voisinage du courant maximal pouvant circuler dans les miroirs, c'est-à-dire le courant débité par la source de courant constant S, puisque c'est pour ces valeurs que l'erreur, en valeur absolue, est la plus importante.

L'analyse détaillée du fonctionnement du circuit simple représenté à la figure 1 montre encore qu'une petite dégradation de la linéarité de la tension de sortie provient de l'effet Early des transistors de sortie 16, 18 des miroirs de courant M₁ et M₂. Cette erreur résiduelle est compensée dans le circuit représenté à la figure 3 au moyen d'un étage cascode constitué par les transistors additionnels 111 et 112 dont les bases sont polarisées à l'aide d'un décalage de tension, par rapport à la source de courant S, produit par deux transistors montés en diodes 61 et 62, en série, qui sont alimentées à partir de la tension d'alimentation V_{cc} par un courant déterminé limité par exemple par une résistance 63. Les collecteurs des transistors 111 et 112 alimentent les charges de sortie constituées par les résistances 31, 32 et les jonctions J₁ et J₂ et produisent les tensions de sortie V₀₁ et V₀₂ sur les bornes de sortie 41 et 42. Enfin les émetteurs des transistors 111 et 112 sont reliés respectivement aux collecteurs des transistors 16 et 18 de la sortie des miroirs de courant M₁ et M₂. Ainsi, ces transistors 16 et 18 fonctionnent à tension V_{ce} pratiquement constante pour la compensation de l'effet Early. En raison des gains limités des transistors 111 et 112, les courants dans les charges de sortie 31, J₁, 32, J₂ sont réduits de la valeur de courant de base desdits transistors. Cette très petite erreur peut encore être compensée par une légère augmentation des résistance de compensation de courant 51 et 52. Les performances du circuit différentiel décrit à la figure 3 sont améliorées par rapport à celui décrit à la figure 1 puisque l'expérience révèle une linéarité meilleure que 1/1000 du signal de sortie même lorsque l'attaque en tension à l'entrée du circuit est faite en mode non symétrique.

Les circuits décrits à titre d'exemple présentent une haute linéarité telle qu'elle est souhaitable dans une application de mesure de tension et notamment dans la conversion de signaux analogiques en signaux numériques. De structure simple, ces circuits peuvent être alimentés avec des courants relativement faibles, par exemple 100µ A, tout en conservant de très bonnes propriétés de bande passante. Bien que les exemples fournis sur les figures présentent des transistors de type NPN, de tels circuits peuvent également être constitués de transistor PNP, en inversant le signe de la tension d'alimentation.

Il doit être entendu que des variantes de réalisation peuvent encore être apportées aux exemples décrits sans sortir pour autant du cadre de l'invention revendiquée ci-après.

## Revendications

1. Circuit différentiel à haute linéarité comportant une source de courant constant alimentant, à partir d'une borne de référence de tension d'alimentation, les trajets émetteur-collecteur d'une paire différentielle de transistors d'entrée, chacun de ces transistors d'entrée ayant son collecteur alimenté à partir d'une autre borne de la tension d'alimentation, sa base qui reçoit un signal de tension d'entrée et son émetteur étant relié à la source de courant constant via une résistance de charge d'émetteur de valeur R, pratiquement identique pour chacun des transistors d'entrée, caractérisé en ce qu'entre l'émetteur de chaque transistor d'entrée et la source de courant est insérée une branche de commande d'un miroir de courant qui comporte q jonctions polarisées en direct, en ce qu'une branche de sortie du miroir de courant est reliée à ladite autre borne d'alimentation via une résistance de charge de sortie, en série avec un nombre non nul k de jonctions polarisées en direct, et en ce que la valeur de chacune des résistances de charge de sortie est choisie pratiquement égale à k.R/(1+q) procurant ainsi un gain de tension en sortie égal à k/(1+q), par rapport au signal de tension d'entrée.

2. Circuit différentiel selon la revendication 1, caractérisé en ce qu'entre l'émetteur de chaque transistor d'entrée et la source de courant est en outre inséré, en série avec la branche de commande du miroir de courant, un nombre p de jonctions polarisées en direct, et en ce que la valeur de chacune des résistances de charge de sortie est choisie pratiquement égale à k.R/(1+p+q) procurant ainsi un gain de tension en sortie égal à k/(1+p+q).

3. Circuit différentiel selon l'une des revendications 1 ou 2, caractérisé en ce que le miroir de courant présente une seule jonction en direct dans sa branche de commande, (q=1).

4. Circuit différentiel selon la revendication 3, caractérisé en ce que dans chacun des miroirs de courant ladite branche de commande comprenant un transistor de commande connecté en diode, l'émetteur de ce transistor de commande est relié à la source de courant constant à travers une résistance de compensation de courant tandis que la branche de sortie du miroir de courant comporte un transistor dont l'émetteur est directement connecté à la source de courant constant.

5. Circuit différentiel selon l'une des revendications 1 à 4, caractérisé en ce que dans chacun des miroirs de courant, ladite branche de sortie comporte un étage cascode constitué par un transistor additionnel dont la base est polarisée à l'aide d'un décalage de tension déterminé par rapport au noeud constitué par la source de courant constant et les miroirs de courant, dont le collecteur alimente la résistance de charge de sortie en série avec le nombre détemriné k de jonctions, et dont l'émetteur est connecté au collecteur du transistor de la branche de sortie du miroir de courant.

## Patentansprüche

1. Eine Differenzschaltung mit hoher Linearität mit einer konstanten Stromversorgungsquelle aus einem Versorgungsspannungsreferenzkontakt, ihre Emitter-Kollektor-Wege eines Differenz-Eingangstransistorpaars, ihre Eingangstransistoren, deren Kollektoren jeweils von einem anderen Versorgungsspannungskontakt versorgt werden, ihre Basis, die ein Eingangsspannungssignal erhält und ihren Emitter, der mit der konstanten Stromversorgungsquelle über einen Emitter-Ladewiderstand des nahezu für jeden der Eingangstransistoren identischen Wertes R verbunden ist, mit dem Merkmal, daß zwischen dem Emitter jedes Eingangstransistors und der Stromquelle ein Steuerzweig eines Stromspiegels eingefügt wird, der q direktpolarisierte Übergänge aufweist, daß ein Ausgangszweig des Stromspiegels über einen Ausgangsladewiderstand in Serie mit einer Anzahl ungleich null k direktpolarisierter Übergänge an den besagten anderen Versorgungskontakt angeschlossen ist, und daß der Wert jedes Ausgangsladewiderstands praktisch gleich k.R/(1+q) gewählt wird, der so eine Ausgangsspannungssteigerung gleich k/(1+q) im Verhältnis zum Eingangsspannungssignal liefert.

2. Eine Differenzschaltung laut Anspruch 1, mit dem Merkmal, daß zusätzlich zwischen dem Emitter jedes Eingangstransistors und der Stromquelle in Serie mit dem Steuerzweig des Stromspiegels eine Anzahl p direktpolarisierter Übergänge eingefügt wird, und daß der Wert jedes der Ladewiderstände praktisch gleich k.R/(1+p+q) gewählt und so eine Steigerung der Ausgangsspannung gleich k/(1+p+q) erhalten wird.

3. Eine Differenzschaltung laut einem der Ansprüche 1 oder 2, mit dem Mermkal, daß der Stromspiegel in seinem Steuerzweig (q=1) einen einzigen direkten Übergang aufweist.

4. Eine Differenzschaltung laut Anspruch 3, mit dem Merkmal, daß in jedem der Stromspiegel der besagte Steuerzweig einen direkt als Diode angeschlossenen Steuertransistor enthält, der Emitter dieses Steuertransistors über einen Stromausgleichwiderstand an die konstante Stromquelle verbunden ist, während der Ausgangszweig des Stromspiegels einen Transistor ausweist, dessen Emitter direkt mit der konstanten Stromquelle verbunden ist.

5. Eine Differenzschaltung laut einem der Ansprüche 1 bis 4, mit dem Merkmal, daß in jedem der Stromspiegel der besagte Ausgangszweig eine Kaskadenstufe aufweist, gebildet von einem zusätzlichen Transistor, dessen Basis unter Zuhilfenahme einer Spannungsverschiebung polarisiert wird, die im Verhältnis zu dem Knoten bestimmt wird, der von der konstanten Stromquelle und den Stromspiegeln gebildet wird, wobei der Kollektor den Ausgangsladewiderstand in Serie mit der bestimmten Anzahl k Übergänge versorgt und der Emitter an den Kollektor des Transistors des Ausgangszweigs des Stromspiegels angeschlossen ist.

## Claims

1. A high linearity differential circuit, comprising a DC current source feeding from a supply voltage reference terminal the emitter-collector paths of a differential pair of input transistors, the collector of each of these input transistors being fed from another supply voltage terminal, the base receiving an input voltage signal and the emitter being connected to the DC current source via an emitter load resistor which has the value R, practically identical for each of the input transistors, characterized in that a control branch of a current mirror, comprising q forward biased junctions is inserted between the emitter of each input transistor and the current source, in that an output branch of the current mirror is connected to said other supply terminal via an output load resistor in series with a non-zero number k of forward biased junctions, and in that the value of each of the output load resistors is selected to be practically equal to k.R/(1+q) so as to obtain in this manner a voltage gain at the output, which gain is equal to k/(1+q) relative to the input voltage signal.

2. A differential circuit as claimed in Claim 1, characterized in that a number p of forward biased junctions in series with the control branch of the current mirror are inserted between the emitter of each input transistor and the current source, and in that the value of each of the output load resistors is selected to be practically equal to k.R/(1+p+q) so that at the output a voltage gain equal to k/(1+p+q) is obtained.

3. A differential circuit as claimed in anyone of Claims 1 or 2, characterized in that the current mirror has a single DC junction in its control branch (q= 1).

4. A differential circuit as claimed in Claim 3, characterized in that in each of the current mirrors said control branch comprises a control transistor arranged as a diode, the emitter of this control transistor being connected to the DC current source through a current compensating resistor, whilst the output branch of the current mirror comprises a transistor whose emitter is directly connected to the DC current source.

5. A differential circuit as claimed in anyone of Claims 1 to 4, characterized in that in each of the current mirrors said output branch comprises a cascode stage constituted by an additional transistor whose base is biased with the aid of a voltage shift determined relative to the node constituted by the DC current source and the current mirrors, whose collector feeds the output load resistor in series with the determined number k of junctions, and whose emitter is connected to the collector of the output branch transistor of the current mirror.
